(19) Europäisches Patentamt / European Patent Office / Office européen des brevets

(11) **EP 4 290 594 A1**

(12) **EUROPEAN PATENT APPLICATION**
published in accordance with Art. 153(4) EPC

(43) Date of publication:
13.12.2023 Bulletin 2023/50

(21) Application number: 22749649.4

(22) Date of filing: 31.01.2022

(51) International Patent Classification (IPC):
$H01L\ 35/08$ (2006.01)  $H01L\ 35/32$ (2006.01)
$H01L\ 35/34$ (2006.01)  $H02N\ 11/00$ (2006.01)

(52) Cooperative Patent Classification (CPC):
H02N 11/00; H10N 10/01; H10N 10/17;
H10N 10/817

(86) International application number:
PCT/JP2022/003553

(87) International publication number:
WO 2022/168777 (11.08.2022 Gazette 2022/32)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 03.02.2021 JP 2021015612
10.12.2021 JP 2021200808

(71) Applicant: Mitsubishi Materials Corporation
Tokyo 100-8117 (JP)

(72) Inventors:
• ARAI, Koya
Saitama-shi, Saitama 330-8508 (JP)
• NISHIMOTO, Shuji
Saitama-shi, Saitama 330-8508 (JP)
• OHASHI, Toyo
Saitama-shi, Saitama 330-8508 (JP)
• NAGATOMO, Yoshiyuki
Saitama-shi, Saitama 330-8508 (JP)

(74) Representative: Hoffmann Eitle
Patent- und Rechtsanwälte PartmbB
Arabellastraße 30
81925 München (DE)

(54) **THERMOELECTRIC CONVERSION MODULE, AND METHOD FOR PRODUCING THERMOELECTRIC CONVERSION MODULE**

(57)     A thermoelectric conversion module (10) includes: a plurality of thermoelectric conversion elements (11) that stand at distances from each other; a first electrode portion (25) disposed at a first end of the thermoelectric conversion elements (11) in a standing direction; and a second electrode portion (35) disposed at a second end in the standing direction, in which the plurality of thermoelectric conversion elements (11) are electrically connected to each other via the first electrode portion (25) and the second electrode portion (35), a first insulating circuit substrate (20) including: a first insulating layer (21) made of ceramic; and the first electrode portion (25) made of a silver sintered body is disposed at the first end, and a second insulating circuit substrate (30) including: a second insulating layer (31) made of ceramic or a resin; a buffering layer (34) made of aluminum or copper; and the second electrode portion (35) is disposed at the second end.

FIG. 1

**Description**

[Technical Field]

The present invention relates to a thermoelectric conversion module in which a plurality of thermoelectric conversion elements are electrically connected to each other, and a method for producing a thermoelectric conversion module.

The present application claims priority on Japanese Patent Application No. 2021-15612 filed on February 3, 2021, and Japanese Patent Application No. 2021-200808 filed on December 10, 2021, the contents of which are incorporated herein by reference.

[Background Art]

A thermoelectric conversion element is an electronic element that enables conversion between thermal energy and electric energy by the Seebeck effect or the Peltier effect.

The Seebeck effect is a phenomenon in which an electromotive force is generated when a temperature difference is generated between both ends of a thermoelectric conversion element, and thermal energy is converted into electric energy. The electromotive force generated by the Seebeck effect is determined by the characteristics of the thermoelectric conversion element. In recent years, thermoelectric power generation utilizing this effect has been actively developed.

The Peltier effect is a phenomenon in which a temperature difference is generated at both ends of a thermoelectric conversion element when an electrode or the like is formed at both ends of the thermoelectric conversion element and a potential difference is generated between the electrodes, and electric energy is converted into thermal energy. An element having this effect is particularly called a Peltier element, and is used for cooling and temperature control of precision instruments, small refrigerators, and the like.

As a thermoelectric conversion module using the above-described thermoelectric conversion element, for example, a structure in which n-type thermoelectric conversion elements and p-type thermoelectric conversion elements are alternately connected in series has been proposed.

This thermoelectric conversion module has a structure in which a heat transfer plate is disposed on each of one end side and the other end side of a plurality of thermoelectric conversion elements, and the thermoelectric conversion elements are connected in series by electrode portions disposed in the heat transfer plates. As the above-described heat transfer plate, an insulating circuit substrate provided with an insulating layer and the electrode portion may be used.

In addition, electric energy can be generated by the Seebeck effect by generating a temperature difference between the heat transfer plate disposed on one end side of the thermoelectric conversion elements and the heat transfer plate disposed on the other end side of the thermoelectric conversion elements. Alternatively, by applying a current to the thermoelectric conversion elements, a temperature difference between the heat transfer plate disposed on one end side of the thermoelectric conversion elements and the heat transfer plate disposed on the other end side of the thermoelectric conversion elements can be generated by the Peltier effect.

In the above-described thermoelectric conversion module, in order to improve thermoelectric conversion efficiency, it is necessary to suppress electrical resistance in the electrode portion connected to the thermoelectric conversion elements to a low level.

Therefore, in the related art, a silver paste or the like having particularly excellent electrical conductivity is used for bonding between a thermoelectric conversion element and an electrode portion. Alternatively, the electrode portion itself may be formed of a silver paste and bonded to the thermoelectric conversion element.

For example, Patent Document 1 discloses a thermoelectric conversion module in which a first insulating circuit substrate provided with a first insulating layer and a first electrode portion made of a silver sintered body which is formed on one surface of the first insulating layer is disposed on one end side of a thermoelectric conversion element and a second insulating circuit substrate provided with a second insulating layer and a second electrode portion made of a Ag sintered body which is formed on one surface of the second insulating layer is disposed on the other end side of the thermoelectric conversion element. In Patent Document 1, the thermoelectric conversion element and either one of the first electrode portion or the second electrode portion are bonded to each other, for example, at a temperature of 350°C to 400°C.

Patent Document 2 discloses a thermoelectric conversion module in which a first insulating circuit substrate provided with a first insulating layer and a first electrode portion formed on one surface of the first insulating layer is disposed on one end side of a thermoelectric conversion element, a second insulating circuit substrate provided with a second insulating layer and a second electrode portion formed on one surface of the second insulating layer is disposed on the other end side of the thermoelectric conversion element, and the first electrode portion and the second electrode portion are formed of an aluminum layer and a silver sintered layer.

Meanwhile, in the thermoelectric conversion module, one end side (first insulating circuit substrate side) of the thermoelectric conversion element is disposed in a high-temperature environment (for example, 400°C to 550°C), and the other end side (second insulating circuit substrate side) of the thermoelectric conversion element is disposed in a low-temperature environment (for example, 50°C to 100°C).

Depending on usage conditions of the thermoelectric conversion module, the high-temperature environment in which one end side (first insulating circuit substrate side) of the thermoelectric conversion element is disposed may be subjected to a thermal cycle of, for example, 150°C and 550°C.

In the thermoelectric conversion module described in Patent Document 1, since the thermoelectric conversion element and either one of the first electrode portion or the second electrode portion are bonded to each other at a temperature of 350°C to 400°C as described above, thermal stress is applied to the second insulating circuit substrate disposed in the low-temperature environment due to a temperature difference between the low-temperature environment and the temperature at the time of bonding, so that there is concern that the thermoelectric conversion element and the second electrode portion are peeled from each other and a service life shortens.

In the thermoelectric conversion module described in Patent Document 2, since the electrode portion has a structure in which the aluminum layer and the silver sintered layer are laminated, Al of the aluminum layer and Ag of the silver sintered layer react with each other to form a hard intermetallic compound at an interface between the aluminum layer and the silver sintered layer in the first insulating circuit substrate disposed in the high-temperature environment, so that there is concern that the interface between the aluminum layer and the silver sintered layer is fractured and broken or the thermoelectric conversion element and the first electrode portion are peeled from each other when a thermal cycle of 150°C and 550°C is applied.

[Citation List]

[Patent Documents]

[Patent Document 1]
Japanese Unexamined Patent Application, First Publication No. 2019-016786
[Patent Document 2]
Japanese Unexamined Patent Application, First Publication No. 2019-012829

[Summary of Invention]

[Technical Problem]

The present invention has been made in view of the above-described circumstances, and an object thereof is to provide a thermoelectric conversion module and a method for producing a thermoelectric conversion module capable of providing excellent bonding reliability between a thermoelectric conversion element and an electrode portion and capable of extending a service life.

[Solution to Problem]

In order to solve the above problems, a thermoelectric conversion module according to an aspect of the present invention includes: a plurality of thermoelectric conversion elements that stand at distances from each other; a first electrode portion disposed at a first end of the thermoelectric conversion elements in a standing direction; and a second electrode portion disposed at a second end in the standing direction, in which the plurality of thermoelectric conversion elements are electrically connected to each other via the first electrode portion and the second electrode portion, a first insulating circuit substrate including: a first insulating layer made of ceramic; and the first electrode portion made of a silver sintered body which is formed on a surface of the first insulating layer is disposed at the first end, and a second insulating circuit substrate including: a second insulating layer made of ceramic or a resin; a buffering layer made of aluminum or copper which is formed on a surface of the second insulating layer; and the second electrode portion laminated on the buffering layer is disposed at the second end.

According to the thermoelectric conversion module according to the aspect of the present invention, since the first insulating circuit substrate disposed at the first end of the thermoelectric conversion elements in the standing direction has a structure including the first insulating layer made of ceramic and the first electrode portion made of the silver sintered body which is formed on the surface of the first insulating layer, even when the first insulating circuit substrate is disposed in a high-temperature environment, no intermetallic compounds are generated at a bonding interface between the thermoelectric conversion elements and the first electrode portion, and even when a thermal cycle of 150°C and 550°C is applied, peeling between the thermoelectric conversion elements and the first electrode portion is suppressed.

In addition, since the second insulating circuit substrate disposed at the second end of the thermoelectric conversion elements in the standing direction has a structure including the second insulating layer made of ceramic or a resin, the buffering layer made of aluminum or copper which is formed on the surface of the second insulating layer, and the second electrode portion laminated on the buffering layer, thermal stress generated by a temperature difference from the temperature at the time of bonding can be relaxed by the buffering layer and peeling between the thermoelectric conversion elements and the second electrode portion can be suppressed.

In the thermoelectric conversion module according to the aspect of the present invention, it is preferable that a thickness of the buffering layer is in a range of 50 $\mu$m or more and 2000 $\mu$m or less.

In this case, since the thickness of the buffering layer of the second insulating circuit substrate is set to be in a range of 50 $\mu$m or more and 2000 $\mu$m or less, the thermal stress generated by a temperature difference from the temperature at the time of bonding can be sufficiently relaxed by the buffering layer and the peeling between the thermoelectric conversion elements and the second electrode portion can be more accurately suppressed.

In addition, in the thermoelectric conversion module according to the aspect of the present invention, it is preferable that a glass component is present at an interface between the first electrode portion and the first insulating layer, and the first electrode portion in at least a region in which the thermoelectric conversion elements are disposed has a thickness of 5 $\mu$m or more and a porosity of less than 10%.

In this case, the first electrode portion is formed to be dense and thick, so that it is possible to reduce the electrical resistance. In addition, since there are few pores inside the first electrode portion, deterioration of the thermoelectric conversion elements due to gas inside the pores can be suppressed. Furthermore, since the glass component is present at the interface between the first electrode portion and the first insulating layer, the first electrode portion and the first insulating layer are firmly bonded to each other due to a reaction between the glass component and ceramic, so that bonding reliability is excellent.

Furthermore, in the thermoelectric conversion module according to the aspect of the present invention, it is preferable that the first electrode portion consists of a glass-containing region and a glass-free region in order from a first insulating layer side in a laminating direction, and when a thickness of the glass-containing region in the laminating direction is indicated as Tg and a thickness of the glass-free region in the laminating direction is indicated as Ta, Ta/(Ta + Tg) is more than 0 and 0.5 or less.

In this case, since the first electrode portion has a structure in which the glass-containing region and the glass-free region are laminated and Ta/(Ta + Tg) is limited to 0.5 or less when the thickness of the glass-containing region in the laminating direction is indicated as Tg and the thickness of the glass-free region in the laminating direction is indicated as Ta, it is possible to suppress the occurrence of peeling at an interface between the glass-containing region and the glass-free region. In addition, since Ta/(Ta + Tg) is more than 0, no glass component is present on a bonding surface to the thermoelectric conversion elements, and it is possible to improve a bonding property between the thermoelectric conversion elements and the first electrode portion.

In addition, in the thermoelectric conversion module according to the aspect of the present invention, it is preferable that the second electrode portion in at least a region in which the thermoelectric conversion elements are disposed has a thickness of 5 $\mu$m or more and a porosity of less than 10%.

In this case, the second electrode portion is formed to be dense and thick, so that it is possible to reduce the electrical resistance. In addition, since there are few pores inside the second electrode portion, deterioration of the thermoelectric conversion elements due to gas inside the pores can be suppressed.

Furthermore, in the thermoelectric conversion module according to the aspect of the present invention, it is preferable that an arithmetic average roughness Ra of a surface of the first electrode portion facing a thermoelectric conversion element side is 1 $\mu$m or less.

In this case, since the arithmetic average roughness Ra of the surface of the first electrode portion made of the silver sintered body facing the thermoelectric conversion element side is 1 $\mu$m or less and the surface is smooth, an initial bonding rate to the thermoelectric conversion elements is excellent, and a change in the electrical resistance during use is small.

In addition, in the thermoelectric conversion module according to the aspect of the present invention, it is preferable that an arithmetic average roughness Ra of a surface of the second electrode portion facing a thermoelectric conversion element side is 1.50 $\mu$m or less.

In this case, since the arithmetic average roughness Ra of the surface of the second electrode portion facing the thermoelectric conversion element side is 1.50 $\mu$m or less and the surface is smooth, an initial bonding rate to the thermoelectric conversion elements is excellent, and a change in the electrical resistance during use is small.

A method for producing a thermoelectric conversion module according to an aspect of the present invention is a method for producing a thermoelectric conversion module that includes: a plurality of thermoelectric conversion elements that stand at distances from each other; a first electrode portion disposed at a first end of the thermoelectric conversion elements in a standing direction; and a second electrode portion disposed at a second end in the standing direction, in which the plurality of thermoelectric conversion elements are electrically connected to each other via the first electrode portion and the second electrode portion, and in the thermoelectric conversion module, a first insulating circuit substrate including: a first insulating layer having at least one surface made of ceramic; and the first electrode portion made of a silver sintered body which is formed on the one surface of the first insulating layer is disposed at the first end, and a second insulating circuit substrate including: a second insulating layer made of ceramic or a resin; a buffering layer made of aluminum or copper which is formed on a surface of the second insulating layer; and the second electrode portion laminated on the buffering layer is disposed at the second end, the method includes: a first electrode portion bonding step of bonding the first end of the thermoelectric conversion elements and the first electrode portion to each other; and a second electrode portion bonding step of bonding the second end of the thermoelectric conversion elements and the second electrode portion to each other, in which the first electrode portion bonding step and the second electrode portion bonding step are simultaneously performed.

According to the method for producing a thermoelectric conversion module according to the aspect of the present invention, since the first electrode portion bonding step of bonding the first end of the thermoelectric conversion elements and the first electrode portion to each other and the second electrode portion bonding step of bonding the second end of the thermoelectric conversion elements and the second electrode portion to each other are simultaneously performed, the thermoelectric conversion module can be produced relatively easily.

In addition, since the buffering layer is formed in the second insulating circuit substrate, even in the case where the first electrode portion bonding step and the second electrode portion bonding step are simultaneously performed, thermal stress due to a temperature difference from the temperature at the time of bonding can be relaxed by the buffering layer in the second insulating circuit substrate disposed in a low-temperature environment, so that peeling between the thermoelectric conversion elements and the second electrode portion can be suppressed.

In the method for producing a thermoelectric conversion module according to the aspect of the present invention, it is preferable that in the first electrode portion bonding step and the second electrode portion bonding step which are simultaneously performed, a pressing load is set to be in a range of 20 MPa or more and 50 MPa or less and a heating temperature is set to be in a range of 300°C or higher and 500°C or lower, and the method further includes: a pressing holding step of subsequently holding the first electrode portion at a temperature of 500°C or higher and 700°C or lower, holding the second electrode portion at a temperature of 100°C or lower, and holding a pressing load to be 1 MPa or more and 50 MPa or less.

In this case, since the thermoelectric conversion elements and either one of the first electrode portion or the second electrode portion are bonded to each other at the above-described pressing load and the heating temperature, the first electrode portion and the second electrode portion can have a dense structure.

In addition, a method for producing a thermoelectric conversion module according to an aspect of the present invention is a method for producing a thermoelectric conversion module that includes: a plurality of thermoelectric conversion elements that stand at distances from each other; a first electrode portion disposed at a first end of the thermoelectric conversion elements in a standing direction; and a second electrode portion disposed at a second end in the standing direction, in which the plurality of thermoelectric conversion elements are electrically connected to each other via the first electrode portion and the second electrode portion, and in the thermoelectric conversion module, a first insulating circuit substrate including: a first insulating layer having at least one surface made of ceramic; and the first electrode portion made of a silver sintered body which is formed on the one surface of the first insulating layer is disposed at the first end, and a second insulating circuit substrate including: a second insulating layer made of ceramic or a resin; a buffering layer made of aluminum or copper which is formed on a surface of the second insulating layer; and the second electrode portion laminated on the buffering layer is disposed at the second end, the method includes: a first electrode portion bonding step of bonding the first end of the thermoelectric conversion elements and the first electrode portion to each other; and a second electrode portion bonding step of bonding the second end of the thermoelectric conversion elements and the second electrode portion to each other, in which, in the first electrode portion bonding step, the thermoelectric conversion elements and the first electrode portion are bonded to each other at a temperature in a range of 300°C or higher and 700°C or lower, and subsequently, in the second electrode portion bonding step, the thermoelectric conversion elements and the second electrode portion are bonded to each other at a temperature in a range of 200°C or higher and 500°C or lower.

According to the method for producing a thermoelectric conversion module according to the aspect of the present invention, since the thermoelectric conversion elements and the first electrode portion are bonded to each other at a temperature in a range of 300°C or higher and 700°C or lower in the first electrode portion bonding step and subsequently, the thermoelectric conversion elements and the second electrode portion are bonded to each other at a temperature in a range of 200°C or higher and 500°C or lower in the second electrode portion bonding step, in the second insulating circuit substrate disposed in the low-temperature environment, a temperature difference from the temperature at the time of bonding can be reduced, so that it is possible to suppress the thermal stress to a low level.

In the method for producing a thermoelectric conversion module according to the aspect of the present invention, it is preferable that in the first electrode portion bonding step, a pressing load is set to be in a range of 20 MPa or more and 50 MPa or less, and a heating temperature is set to be in a range of 300°C or higher and 500°C or lower.

In this case, since the thermoelectric conversion elements and the first electrode portion are bonded to each other at the above-described pressing load and the heating temperature, the first electrode portion can have a dense structure.

[Advantageous Effects of Invention]

According to the aspects of the present invention, it is possible to provide a thermoelectric conversion module and a method for producing a thermoelectric conversion module capable of providing excellent bonding reliability between a thermoelectric conversion element and an electrode portion and capable of extending a service life.

[Brief Description of Drawings]

FIG. 1 is a schematic explanatory view of a thermoelectric conversion module according to an embodiment of the present invention.
FIG. 2 is a schematic explanatory view showing a glass-containing region and a glass-free region in a first electrode portion.
FIG. 3 is a flowchart showing a method for producing a thermoelectric conversion module according to the embodiment of the present invention.
FIG. 4 is a schematic explanatory view showing the method for producing a thermoelectric conversion module (a method for producing a second insulating circuit substrate) according to the embodiment of the present invention.
FIG. 5 is a schematic explanatory view showing the method for producing a thermoelectric conversion module according to the embodiment of the present invention.
FIG. 6 is a flowchart showing a method for producing a thermoelectric conversion module according to another embodiment of the present invention.

[Description of Embodiments]

Hereinafter, embodiments of the present invention will be described with reference to the accompanying drawings. Each embodiment to be described below is specifically described for better understanding of the features of the invention, and does not limit the present invention unless otherwise specified. In addition, in the drawings used in the following description, for convenience, in order to make the features of the present invention easy to understand, a portion that is a main part may be enlarged in some cases, and a dimensional ratio or the like of each component is not always the same as an actual one.

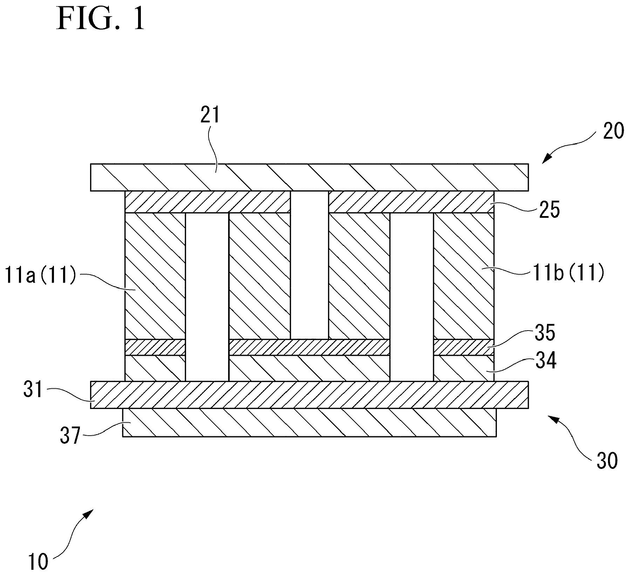

As shown in FIG. 1, a thermoelectric conversion module 10 according to the present embodiment includes a plurality of thermoelectric conversion elements 11 that stand at distances from each other, a first insulating circuit substrate 20 disposed at a first end (upper end in FIG. 1) of the thermoelectric conversion elements 11 in a standing direction, and a second insulating circuit substrate 30 disposed at a second end (lower end in FIG. 1) of the thermoelectric conversion elements 11 in the standing direction.

As shown in FIG. 1, a first electrode portion 25 is formed in the first insulating circuit substrate 20 disposed at the first end of the thermoelectric conversion elements 11, a second electrode portion 35 is formed in the second insulating circuit substrate 30 disposed at the second end of the thermoelectric conversion elements 11, and the plurality of columnar thermoelectric conversion elements 11 are electrically connected in series by the first electrode portion 25 and the second electrode portion 35.

The first insulating circuit substrate 20 includes a first insulating layer 21 and the first electrode portion 25 formed on one surface (lower surface in FIG. 1) of the first insulating layer 21.

The first insulating layer 21 of the first insulating circuit substrate 20 (first insulating circuit substrate) is made of ceramic. As the ceramic forming the first insulating layer 21, for example, aluminum nitride (AlN), silicon nitride ($Si_3N_4$), or alumina ($Al_2O_3$) can be applied.

A thickness of the first insulating layer 21 may be set to be in a range of 100 $\mu$m or more and 2000 $\mu$m or less.

It is preferable that the first electrode portion 25 is made of a silver sintered body, and at least a lowermost layer thereof in contact with one surface of the first insulating layer 21 made of ceramic is made of a sintered body of a glass-containing silver paste containing a glass component. In the present embodiment, the entire first electrode portion 25 may be made of the sintered body of the glass-containing silver paste, and in the first electrode portion 25, a glass-containing region 25A including a glass component and a glass-free region 25B including no glass component may be laminated in order from a first insulating layer 21 side in a laminating direction. The first electrode portion 25 is formed in a pattern on the one surface (the lower surface in FIG. 1) of the first insulating layer 21.

It is preferable that the first electrode portion 25 in at least a region in which the thermoelectric conversion elements 11 are disposed has a thickness of 5 μm or more and a porosity P of less than 10%. In addition, an upper limit of the thickness of the first electrode portion 25 in at least the region in which the thermoelectric conversion elements 11 are disposed is more preferably 500 μm or less. In addition, the porosity P can be reduced to 0%.

In the present embodiment, the porosity P of the first electrode portion 25 was calculated as follows. A cross section of the first electrode portion 25 was mechanically polished, then Ar ion etching (Cross Section Polisher SM-09010 manufactured by JEOL Ltd.) was performed, and the cross section was observed using a laser microscope (VKX-200 manufactured by KEYENCE CORPORATION). The obtained image was subjected to binarization, and white portions were identified as Ag and black portions were identified as pores. From the binarized image, an area of the black portions was obtained, and a porosity was calculated by the following formula. Measurement was performed on five cross sections, and porosities of the cross sections were arithmetically averaged to obtain the porosity P of the first electrode portion 25.

$$\text{Porosity P} = \text{area of black portions (pores)} \,/\, \text{observed area of the first electrode portion 25}$$

In the present embodiment, as described above, since at least the lowermost layer of the first electrode portion 25 in contact with one surface of the first insulating layer 21 made of ceramic is made of the sintered body of the glass-containing silver paste containing a glass component, the glass component is present at an interface between the first insulating layer 21 and the first electrode portion 25.

In the present embodiment, in a case where the entire first electrode portion 25 is made of the sintered body of the glass-containing silver paste, glass particles are dispersed in the first electrode portion 25. The glass particles are present at the interface between the first insulating layer 21 and the first electrode portion 25. In addition, a part of the glass component infiltrates into the first insulating layer 21 side.

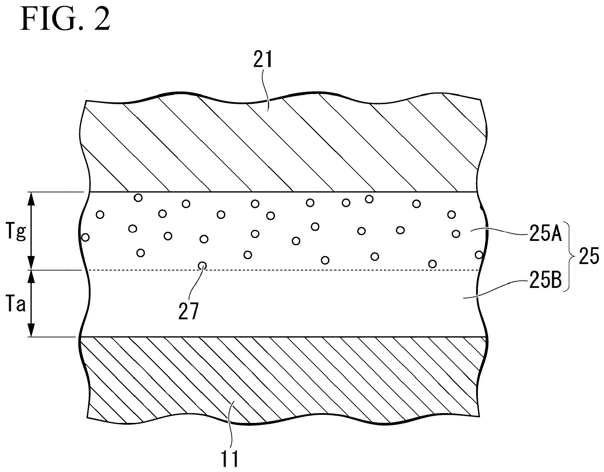

In addition, in the present embodiment, as shown in FIG. 2, in a case where the first electrode portion 25 consists of the glass-containing region 25A including a glass component and the glass-free region 25B including no glass component in order from the first insulating layer 21 side in the laminating direction, when a thickness of the glass-containing region 25A in the laminating direction is indicated as Tg and a thickness of the glass-free region 25B in the laminating direction is indicated as Ta, it is preferable that Ta/(Ta + Tg) is more than 0 and 0.5 or less.

As shown in FIG. 2, the thickness Tg of the glass-containing region 25A in the laminating direction is defined as a thickness up to a glass particle 27 present at the farthest position from the first insulating layer 21 in the laminating direction. In addition, the thickness Ta of the glass-free region 25B in the laminating direction is defined as a value obtained by subtracting the thickness Tg of the glass-containing region 25A in the laminating direction from the thickness of the first electrode portion 25.

Furthermore, in the present embodiment, it is preferable that an arithmetic average roughness Ra of a surface of the first electrode portion 25 facing a thermoelectric conversion element 11 side is 1 μm or less. A lower limit of the arithmetic average roughness Ra of the surface of the first electrode portion 25 facing the thermoelectric conversion element 11 side is not particularly limited, but is preferably set to be 1 nm or more.

The arithmetic average roughness Ra of the surface of the first electrode portion 25 facing the thermoelectric conversion element 11 side can be adjusted by performing polishing.

The second insulating circuit substrate 30 includes a second insulating layer 31, a buffering layer 34 formed on the other surface (upper surface in FIG. 1) of the second insulating layer 31, and the second electrode portion 35 formed on the other surface of the buffering layer 34.

In the present embodiment, in the second insulating circuit substrate 30, as shown in FIG. 1, a heat dissipation layer 37 is formed on one surface (lower surface in FIG. 1) of the second insulating layer 31.

The second insulating layer 31 is made of a highly insulating ceramic material such as aluminum nitride (AlN), silicon nitride ($Si_3N_4$), and alumina ($Al_2O_3$), or an insulating resin. In the present embodiment, the second insulating layer 31 is made of aluminum nitride (AlN). A thickness of the second insulating layer 31 made of aluminum nitride is set to be in a range of 20 μm or more and 2000 μm or less.

As shown in FIG. 1, the buffering layer 34 and the second electrode portion 35 are formed in a pattern on the other surface (upper surface in FIG. 1) of the second insulating layer 31.

The buffering layer 34 is made of aluminum or copper. In the present embodiment, the buffering layer 34 is made of aluminum having a purity of 99 mass% or more, aluminum having a purity of 99.99 mass% or more, copper having a purity of 99 mass% or more, or copper having a purity of 99.96 mass% or more.

In addition, in the present embodiment, the buffering layer 34 preferably has a thickness in a range of 50 μm or more and 2000 μm or less.

The second electrode portion 35 is made of silver or gold, and a lowermost layer thereof in contact with the other surface of the buffering layer 34 is formed of a diffusion prevention layer such as nickel or a sintered body of a glass-containing silver paste containing a glass component. In the present embodiment, the entire second electrode portion 35 is made of the sintered body of the glass-containing silver paste.

The second electrode portion 35 in at least a region in which the thermoelectric conversion elements 11 are disposed has a thickness of 5 $\mu$m or more.

The thickness of the second electrode portion 35 is preferably set to be 5 $\mu$m or more. By setting the thickness of the second electrode portion 35 to be 5 $\mu$m or more, electrical resistance can be reliably reduced. In addition, the thickness of the second electrode portion 35 is preferably 500 $\mu$m or less. By setting the thickness of the second electrode portion 35 to be 500 $\mu$m or less, it is possible to suppress the generation of a large thermal stress in the thermoelectric conversion element 11 when a thermal cycle is applied, and it is possible to prevent the occurrence of breaking.

Therefore, the thickness of the second electrode portion 35 is preferably set to be in a range of 5 $\mu$m or more and 500 $\mu$m or less. A lower limit of the thickness of the second electrode portion 35 is more preferably set to be 50 $\mu$m or more, and an upper limit of the thickness of the second electrode portion 35 is more preferably set to be 200 $\mu$m or less.

However, in a case where the second electrode portion 35 is formed by plating or the like and there is electrical conduction between the second electrode portion 35 and the buffering layer 34, the total thickness of the second electrode portion 35 and the buffering layer 34 may be 53 $\mu$m or more.

In addition, the second electrode portion 35 in at least the region in which the thermoelectric conversion elements 11 are disposed has a porosity P of less than 10%. The porosity P of the second electrode portion 35 can be calculated in the same manner as that of the first electrode portion 25.

In a case where the buffering layer 34 is made of aluminum, an oxide film naturally occurring in the atmosphere is formed on the surface of the buffering layer 34. In the present embodiment, since the lowermost layer of the second electrode portion 35 is made of the sintered body of the glass-containing silver paste, the oxide film is removed by the glass component, and the buffering layer 34 and the second electrode portion 35 are firmly bonded together.

In addition, the second electrode portion 35 made of silver or gold may be disposed on the buffering layer 34 by plating or the like. In this case, a nickel underlayer or the like may be formed on copper or aluminum by a plating treatment, and silver or gold plating may be performed thereon. In addition, in a case where the second electrode portion 35 is a plated layer of silver or gold, the porosity P is approximately 0%.

Furthermore, in the present embodiment, it is preferable that an arithmetic average roughness Ra of a surface of the second electrode portion 35 facing the thermoelectric conversion element 11 side is set to be 1.50 $\mu$m or less. A lower limit of the arithmetic average roughness Ra of the surface of the second electrode portion 35 facing the thermoelectric conversion element 11 side is not particularly limited, but is preferably set to be 1 nm.

The arithmetic average roughness Ra of the surface of the second electrode portion 35 facing the thermoelectric conversion element 11 side can be adjusted by polishing or blasting, which will be described later.

The heat dissipation layer 37 is made of aluminum or copper. In the present embodiment, similarly to the buffering layer 34, the heat dissipation layer 37 is made of aluminum having a purity of 99 mass% or more or copper having a purity of 99 mass% or more.

It is preferable that the heat dissipation layer 37 is made of 4N aluminum having a purity of 99.99 mass% or more or copper (oxygen-free copper (OFC)) having a purity of 99.96 mass% or more.

The thermoelectric conversion elements 11 include n-type thermoelectric conversion elements 11a and p-type thermoelectric conversion elements 11b, and the n-type thermoelectric conversion element 11a and the p-type thermoelectric conversion element 11b are alternately arranged.

A metallized layer (not shown) is formed on each of a first end surface and a second end surface of the thermoelectric conversion elements 11. As the metallized layer, for example, nickel, silver, cobalt, tungsten, molybdenum, or a nonwoven fabric made of fibers of such metals can be used. Furthermore, it is preferable that an outermost surface (bonding surface to the first electrode portion 25 and the second electrode portion 35) of the metallized layer is made of Au or Ag.

For example, the n-type thermoelectric conversion elements 11a and the p-type thermoelectric conversion elements 11b are made of sintered bodies of tellurium compounds, skutterudites, filled skutterudites, Heuslers, half-Heuslers, clathrates, silicides, oxides, or silicon-germanium.

As a material of the n-type thermoelectric conversion element 11a, for example, $Bi_2Te_3$, $PbTe$, $La_3Te_4$, $CoSb_3$, $FeVAl$, $ZrNiSn$, $Ba_8Al_{16}Si_{30}$, $Mg_2Si$, $FeSi_2$, $SrTiO_3$, $CaMnO_3$, $ZnO$, or $SiGe$ is used.

In addition, as a material of the p-type thermoelectric conversion element 11b, for example, $Bi_2Te_3$, $Sb_2Te_3$, $PbTe$, $TAGS$ (= Ag-Sb-Ge-Te), $Zn_4Sb_3$, $CoSb_3$, $CeFe_4Sb_{12}$, $Yb_{14}MnSb_{11}$, $FeVAl$, $MnSi_{1.73}$, $FeSi_2$, $Na_xCoO_2$ $Ca_3Co_4O_7$, $Bi_2Sr_2Co_2O_7$, or $SiGe$ is used.

It is noted that there are a compound that can be both n-type and p-type by a dopant, and a compound that has only one of n-type and p-type properties.

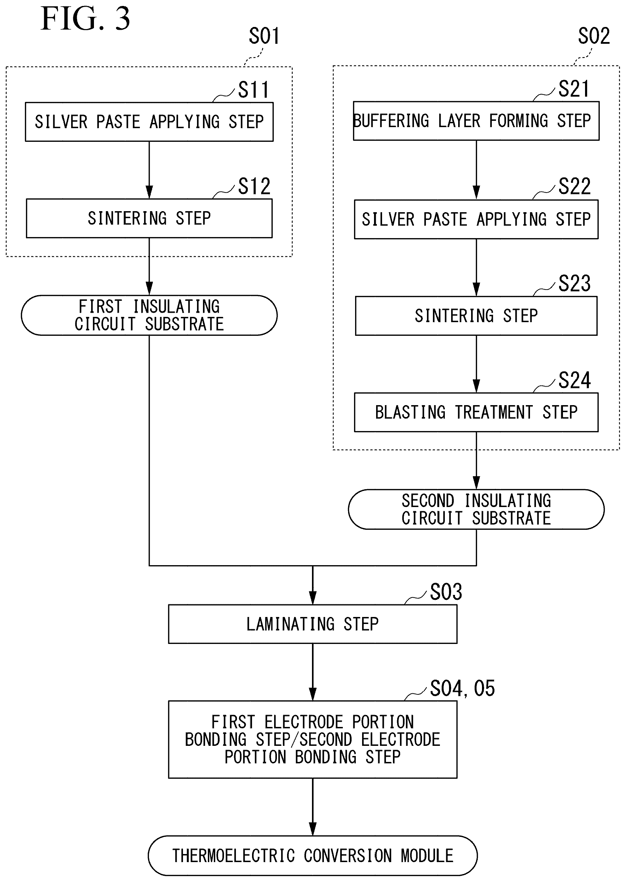

Next, a method for producing the thermoelectric conversion module 10 in the present embodiment described above, will be described with reference to FIGS. 3 to 5.

(First Insulating Circuit Substrate Producing Step S01)

First, the first insulating circuit substrate 20 disposed at the first end in the standing direction of the plurality of thermoelectric conversion elements 11 that stand at distances from each other is produced.

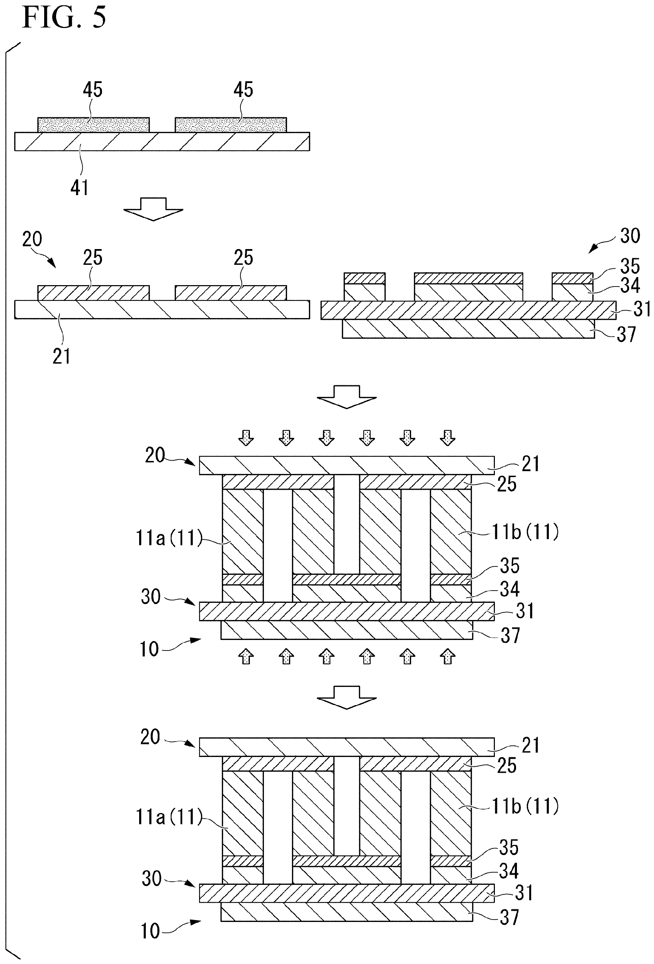

As shown in FIG. 5, a silver paste 45 containing Ag is applied to one surface of a first ceramic plate 41 which is to be the first insulating layer 21 (silver paste applying step S11).

At this time, an applied thickness is set to be preferably more than 5 $\mu$m, preferably more than 20 $\mu$m, and more preferably 50 $\mu$m or more. An applying method is not particularly limited, and various methods such as screen-printing, offset printing, and a photosensitive process can be adopted. At this time, a glass-containing silver paste including a glass component is applied as at least the lowermost layer in contact with the first insulating layer 21 (first ceramic plate 41).

In order to set the applied thickness to be more than 20 $\mu$m, the paste may be repeatedly applied and dried. In this case, a glass-containing paste may be applied as the lowermost layer in contact with the first insulating layer 21 (first ceramic plate 41), and then a silver paste containing no glass component may be applied.

Alternatively, a silver paste containing no glass component may be applied as an uppermost layer in contact with the thermoelectric conversion elements 11.

Furthermore, the glass-containing paste may be applied as the lowermost layer in contact with the first insulating layer 21 (first ceramic plate 41), an intermediate glass-containing paste including a smaller glass content than that in the glass-containing paste may be applied onto the glass-containing paste, and the silver paste containing no glass component may be applied onto the intermediate glass-containing paste.

In addition, in a case where the paste is applied a plurality of times, it is preferable to apply the next paste after drying the applied paste. Furthermore, the applied paste may be once sintered, and then the next paste may be applied.

In a case where the silver paste containing no glass component is applied as the uppermost layer in contact with the thermoelectric conversion element 11, it is preferable that Ta/(Ta + Tg) described above is set to be in a range of more than 0 and 0.5 or less by adjusting the applied thickness of the silver paste and controlling the thickness of the glass-free region 25B.

In the present embodiment, as shown in FIG. 5, the glass-containing silver paste (silver paste 45) is applied to one surface of the first insulating layer 21 (first ceramic plate 41) up to a thickness of more than 50 $\mu$m in each application.

The glass-containing silver paste that forms the first electrode portion 25 in the present embodiment will be described.

This glass-containing silver paste contains a silver powder, a glass powder, a resin, a solvent, and a dispersant, and the amount of powder components consisting of the silver powder and the glass powder is set to be 60 mass% or more and 90 mass% or less of the entire glass-containing silver paste, and a balance thereof includes the resin, the solvent, and the dispersant.

In the present embodiment, the amount of the powder components consisting of the silver powder and the glass powder is set to be 85 mass% of the entire glass-containing silver paste.

A viscosity of the glass-containing silver paste is adjusted to 10 Pa·s or more and 500 Pa·s or less, and more preferably 50 Pa·s or more and 300 Pa·s or less.

The silver powder has a particle size of 0.05 $\mu$m or more and 1.0 $\mu$m or less, and in the present embodiment, a silver powder having an average particle size of 0.8 $\mu$m is used.

The glass powder contains, for example, any one or two or more of lead oxide, zinc oxide, silicon oxide, boron oxide, phosphorus oxide, and bismuth oxide.

A solvent having a boiling point of 200°C or higher is suitable, and in the present embodiment, diethylene glycol dibutyl ether is used.

The viscosity of the glass-containing silver paste is adjusted by the resin, and a resin that is decomposed at a temperature of 400°C or higher is suitable. In the present embodiment, ethyl cellulose is used.

In addition, in the present embodiment, a dicarboxylic acid-based dispersant is added. The glass-containing silver paste may be prepared without adding the dispersant.

This glass-containing silver paste is produced by: premixing a mixed powder in which the silver powder and the glass powder are mixed, and an organic mixture in which the solvent and the resin are mixed, together with the dispersant with a mixer; mixing the obtained premixture with a roll mill while kneading the premixture; and filtering the obtained kneaded material through a paste filter.

As the glass-containing silver paste, a paste primarily containing silver as an electrically conductive metal and containing a glass frit for bonding to a ceramic substrate can be used. For example, a paste for LTCC manufactured by DAIKEN CHEMICAL, or a glass-containing silver paste such as TDPAG-TS1002 manufactured by AS ONE Corporation and DD-1240D manufactured by Kyoto Elex Co., Ltd. can be used. In the present embodiment, DD-1240D manufactured by Kyoto Elex Co., Ltd. is used.

Next, the silver paste 45 is sintered by performing a heat treatment in a state in which the silver paste 45 is each applied to one surface of the first insulating layer 21 (first ceramic plate 41) (sintering step S12).

A drying treatment for removing the solvent of the silver paste 45 may be performed before the sintering. Accordingly, the first electrode portion 25 is formed.

In the sintering step S12, it is preferable that the sintering is performed in an air atmosphere under conditions where a heating temperature is 800°C or higher and 900°C or lower, and a holding time is 10 minutes or longer and 60 minutes or shorter at the heating temperature.

Annealing may be performed after the sintering step S12. By performing the annealing, the first electrode portion 25 can be formed into a denser sintered body. As for annealing conditions, annealing may be performed at a temperature of 700°C to 850°C for 1 to 24 hours.

(Second Insulating Circuit Substrate Producing Step S02)

Next, the second insulating circuit substrate 30 disposed at the second end in the standing direction of the plurality of thermoelectric conversion elements 11 that stand at distances from each other is produced.

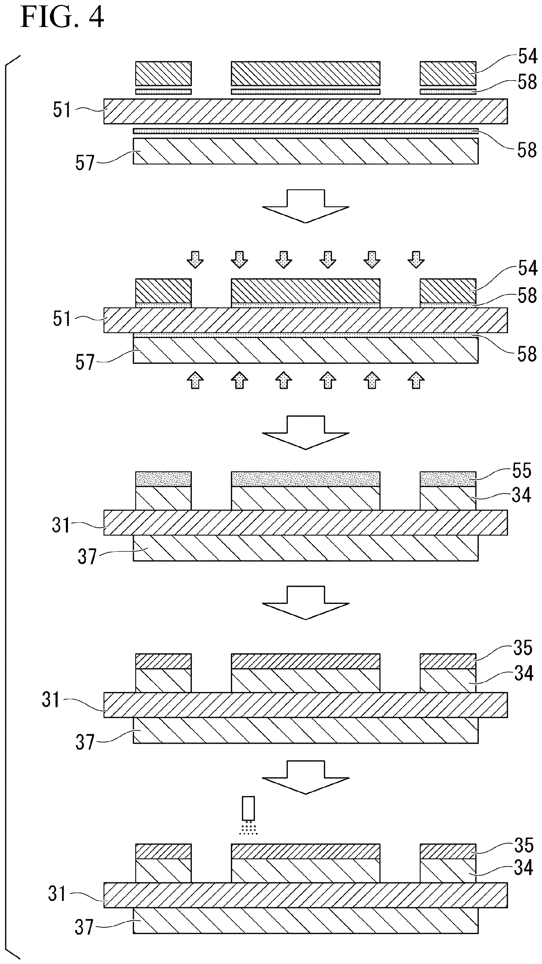

As shown in FIG. 4, a metal plate 54 is bonded to one surface of a second ceramic plate 51 which is to be the second insulating layer 31 to form the buffering layer 34 (buffering layer forming step S21).

In the present embodiment, in the buffering layer forming step S21, the heat dissipation layer 37 is formed by bonding a heat dissipation metal plate 57 to the other surface of the second insulating layer 31 (second ceramic plate 51).

The buffering layer 34 and the heat dissipation layer 37 may be formed into desired shapes by bonding one metal plate 54 having the same thickness as the second insulating layer 31 by using a brazing material 58, and then performing an etching treatment.

In the present embodiment, as the metal plate 54 and the heat dissipation metal plate 57, a 2N aluminum plate having a purity of 99 mass% or more, a 4N aluminum plate having a purity of 99.99 mass% or more, a copper plate having a purity of 99 mass% or more, or a copper plate having a purity of 99.96 mass% or more is used.

A method of bonding the metal plate 54 and the heat dissipation metal plate 57 to the second insulating layer 31 (second ceramic plate 51) is not particularly limited, and for example, bonding using an Al-Si-based brazing material or solid-phase diffusion bonding may be applied. Alternatively, bonding may be performed by a transient liquid phase (TLP) bonding method in which additive elements such as Cu and Si are fixed to a bonding surface and these additive elements are allowed to diffuse to melt and solidify.

In the present embodiment, as shown in FIG. 4, the metal plate 54 and the heat dissipation metal plate 57 are bonded to the second insulating layer 31 (second ceramic plate 51) using the Al-Si-based brazing material 58, and a circuit is formed by etching.

Next, a silver paste 55 containing Ag is applied to one surface of the buffering layer 34 (silver paste applying step S22).

An applying method is not particularly limited, and various methods such as screen-printing, offset printing, and a photosensitive process can be adopted. At this time, a glass-containing silver paste including a glass component is applied as at least the lowermost layer in contact with the buffering layer 34.

In order to secure an applied thickness, the paste may be repeatedly applied and dried. In this case, the glass-containing paste may be applied as the lowermost layer in contact with the buffering layer 34, and then a silver paste containing no glass component may be applied.

In addition, in the present embodiment, as shown in FIG. 4, the glass-containing silver paste is applied to one surface of the buffering layer 34 up to a thickness of more than 5 $\mu$m in each application. In addition, the applied thickness is preferably set to be 7 $\mu$m or more.

As the glass-containing silver paste forming the second electrode portion 35, a silver paste containing a glass frit for low-temperature sintering is preferable. In the present embodiment, a glass powder primarily containing zinc oxide, boron oxide, and bismuth oxide and having an average particle size of 0.5 $\mu$m is used as the glass frit for low-temperature sintering.

In addition, a weight ratio A/G of a weight A of the silver powder and a weight G of the glass powder is adjusted to be in a range of 80/20 to 99/1, and in the present embodiment, A/G is adjusted to 80/5.

Next, the silver paste 55 is sintered by performing a heat treatment in a state where the silver paste 55 is applied to one surface of the buffering layer 34 (sintering step S23).

A drying treatment for removing a solvent of the silver paste 55 may be performed before the sintering. Accordingly, the second electrode portion 35 having a thickness of 5 $\mu$m or more is formed on the buffering layer 34.

In the sintering step S23, it is preferable that the sintering is performed in an air atmosphere under conditions where a heating temperature is 400°C or higher and 600°C or lower, and a holding time is 1 minute or longer and 60 minutes or shorter at the heating temperature.

In addition, the second electrode portion 35 may be subjected to a blasting treatment as necessary (blasting treatment step S24). Alternatively, the second electrode portion 35 may be subjected to polishing.

For example, in a case where the thickness of the second electrode portion 35 is 5 $\mu$m or more and less than 20 $\mu$m, it is preferable to perform the blasting treatment step S24.

In a case where the blasting treatment step S24 is performed, irregularities corresponding to colliding blasting particles are formed on the surface of the second electrode portion 35 after the blasting treatment.

A surface roughness Ra of the second electrode portion 35 after the blasting treatment or the polishing is preferably set to be 0.35 $\mu$m or more and 1.50 $\mu$m or less. By setting the surface roughness Ra after the blasting treatment to be 0.35 $\mu$m or more, electrical resistance between the second electrode portion 35 and the buffering layer 34 can be sufficiently reduced. On the other hand, by setting the surface roughness Ra after the blasting treatment or the polishing to be 1.50 $\mu$m or less, the thermoelectric conversion elements 11 can be favorably bonded.

In this blasting treatment step S24, as the blasting particles, particles having a new Mohs hardness of 2 to 7, for example, glass particles such as silica or the like, ceramic particles, metal particles, resin beads, or the like can be used. In the present embodiment, glass particles are used. In addition, a particle size of the blasting particles is set to be in a range of 5 $\mu$m or more and 150 $\mu$m or less.

In addition, a blasting pressure is set to be in a range of 0.1 MPa or more and 0.8 MPa or less, and a processing time is set to be in a range of 2 seconds or longer and 60 seconds or shorter.

In a case where the thickness of the second electrode portion 35 is less than 5 $\mu$m, a part of the second electrode portion 35 is buried into the buffering layer 34 by the blasting treatment, and a bonding property between the thermoelectric conversion element 11 and the second electrode portion 35 decreases.

After the blasting treatment step S24, a silver paste containing no glass may be applied, dried, and sintered to set the thickness of the second electrode portion 35 to be 5 $\mu$m or more.

Whether or not the blasting treatment step S24 is performed is preferably determined based on the following criteria.

In the thermoelectric conversion module 10 in the present embodiment, it is preferable to form the second electrode portion 35 so that an electrical resistance between the two connected thermoelectric conversion elements 11 and 11 is 1/10 or less of an electrical resistance of the thermoelectric conversion element 11 itself. Specifically, it is preferable that the electrical resistance between the two connected thermoelectric conversion elements 11 and 11 is in a range of 1 n$\Omega$ or more and 1 $\Omega$ or less.

As the electrical resistance between the thermoelectric conversion elements 11 and 11 increases, power to be generated decreases. Therefore, the electrical resistance between the thermoelectric conversion elements 11 and 11 is preferably as low as possible.

In a case where the thickness of the second electrode portion 35 is large and electrical conductivity of the second electrode portion 35 is secured, it is not necessary to perform the blasting treatment step S24. On the other hand, in a case where the thickness of the second electrode portion 35 is small and the electrical conductivity of the second electrode portion 35 is insufficient, it is preferable that the blasting treatment step S24 is performed to secure the electrical conductivity by the second electrode portion 35 and the buffering layer 34.

In the present embodiment, the second electrode portion 35 made of the silver sintered body is formed. However, the second electrode portion 35 may be formed on one surface of the buffering layer 34 by silver plating or gold plating. A plating method may be any known method, and nickel plating may be performed to form an underlayer for silver plating or gold plating.

(Laminating Step S03)

Next, the first insulating circuit substrate 20 is disposed at the first end (upper end in FIG. 5) of the thermoelectric conversion elements 11 and the second insulating circuit substrate 30 is disposed at the second end (lower end in FIG. 5) of the thermoelectric conversion elements 11.

(First Electrode Portion Bonding Step S04 and Second Electrode Portion Bonding Step S05)

Next, the first insulating circuit substrate 20, the thermoelectric conversion elements 11, and the second insulating circuit substrate 30 are pressed in the laminating direction and heated to bond the thermoelectric conversion elements 11 and the first electrode portion 25 to each other and to bond the thermoelectric conversion elements 11 and the second electrode portion 35 to each other. In the present embodiment, the thermoelectric conversion elements 11 are bonded to the first electrode portion 25 and the second electrode portion 35 by solid-phase diffusion bonding.

That is, in the present embodiment, bonding between the first end of the thermoelectric conversion elements 11 and the first electrode portion 25 of the first insulating circuit substrate 20, and bonding between the second end of the thermoelectric conversion elements 11 and the second electrode portion 35 of the second insulating circuit substrate 30 are simultaneously performed.

In a first electrode portion bonding step S04 and a second electrode portion bonding step S05, a pressing load is set to be in a range of 20 MPa or more and 50 MPa or less, and a heating temperature is set to be 300°C or higher. In the present embodiment, a holding time at the heating temperature mentioned above is set to be in a range of 5 minutes or longer and 60 minutes or shorter, and an atmosphere is set to a vacuum atmosphere.

In a case where the pressing load in the first electrode portion bonding step S04 and the second electrode portion bonding step S05 is less than 20 MPa, there is concern that solid-phase diffusion bonding between either one of the first electrode portion 25 or the second electrode portion 35 and the thermoelectric conversion elements 11 cannot be achieved. On the other hand, in a case where the pressing load in the first electrode portion bonding step S04 and the second electrode portion bonding step S05 is more than 50 MPa, there is concern that breaking occurs in the thermoelectric conversion elements 11 and in the first insulating layer 21 and the second insulating layer 31 which are made of ceramic.

Therefore, in the present embodiment, the pressing load in the first electrode portion bonding step S04 and the second electrode portion bonding step S05 is set to be in a range of 20 MPa or more and 50 MPa or less.

In addition, in order to ensure the bonding between the first electrode portion 25 and the thermoelectric conversion elements 11 and the bonding between the second electrode portion 35 and the thermoelectric conversion elements 11, a lower limit of the pressing load in the first electrode portion bonding step S04 and the second electrode portion bonding step S05 is set to be preferably 20 MPa or more, and more preferably 30 MPa or more. On the other hand, in order to reliably suppress the occurrence of breaking in the thermoelectric conversion elements 11 and in the first insulating layer 21 and the second insulating layer 31 which are made of ceramic, an upper limit of the pressing load in the first electrode portion bonding step S04 and the second electrode portion bonding step S05 is set to be preferably 50 MPa or less, and more preferably 40 MPa or less.

In addition, in a case where the heating temperature in the first electrode portion bonding step S04 and the second electrode portion bonding step S05 is lower than 300°C, there is concern that the thermoelectric conversion elements 11 and either one of the first electrode portion 25 or the second electrode portion 35 cannot be bonded to each other.

Furthermore, in a case where the first electrode portion bonding step S04 and the second electrode portion bonding step S05 are performed simultaneously, the heating temperature is preferably set to be 500°C or lower. In a case where the heating temperature is higher than 500°C, there is concern that the second electrode portion 35 and the buffering layer 34 may react with each other.

In addition, in order to reliably bond the thermoelectric conversion elements 11 and the first electrode portion 25 to each other and to reliably bond the thermoelectric conversion elements 11 and the second electrode portion 35 to each other, a lower limit of the heating temperature in the first electrode portion bonding step S04 and the second electrode portion bonding step S05 is preferably set to be 350°C or higher. On the other hand, in order to reliably suppress thermal decomposition of the thermoelectric conversion element 11, an upper limit of the heating temperature in the first electrode portion bonding step S04 and the second electrode portion bonding step S05 is more preferably set to be 400°C or lower.

As a general and well-known technique, a silver paste or solder may be used for bonding between the thermoelectric conversion elements 11 and either one of the first electrode portion 25 or the second electrode portion 35, and in this case, bonding can be performed at a load of 20 MPa or less.

Next, it is preferable that the temperature of the first electrode portion 25 is set to be 500°C or higher and 700°C or lower, the temperature of the second electrode portion 35 is set to be 100°C or lower, and holding is performed at a pressing load of 1 MPa or more and 50 MPa or less (pressing holding step). In this case, since the first electrode portion 25 and the second electrode portion 35 are bonded to the thermoelectric conversion elements 11 at the above-described pressing load and the heating temperature, the first electrode portion 25 and the second electrode portion 35 can have a dense structure.

As described above, the thermoelectric conversion module 10 according to the present embodiment is produced.

The thermoelectric conversion module 10 in the present embodiment thus obtained is used, for example, in a state where a first insulating circuit substrate 20 side is disposed in a high-temperature environment, a second insulating circuit substrate 30 side is disposed in a low-temperature environment, and conversion between thermal energy and electric energy is performed.

In the thermoelectric conversion module 10 in the present embodiment having the configuration as described above, since the first insulating circuit substrate 20 disposed at the first end in the standing direction of the plurality of thermoelectric conversion elements 11 that stand at distances from each other has a structure including the first insulating layer 21 made of ceramic and the first electrode portion 25 formed on the surface of the first insulating layer 21 and made of the silver sintered body, even when the first insulating circuit substrate 20 is disposed in the high-temperature environment, no intermetallic compounds are generated, and even when a thermal cycle of 150°C and 550°C is applied, peeling between the thermoelectric conversion elements 11 and the first electrode portion 25 is suppressed.

In addition, since the second insulating circuit substrate 30 disposed at the second end in the standing direction of the plurality of thermoelectric conversion elements 11 that stand at distances from each other has a structure including the second insulating layer 31 made of ceramic or a resin, the buffering layer 34 made of aluminum or copper and formed on the surface of the second insulating layer 31, and the second electrode portion 35 laminated on the buffering layer 34, thermal stress generated by a temperature difference between the heating temperature in the second electrode portion bonding step S05 and the temperature during use can be relaxed by the buffering layer 34 and the peeling between the thermoelectric conversion elements 11 and the second electrode portion 35 can be suppressed.

In the present embodiment, in a case where the thickness of the buffering layer 34 is in a range of 50 $\mu$m or more and 2000 $\mu$m or less, the thermal stress generated by a temperature difference between the heating temperature in the second electrode portion bonding step S05 and the temperature during use can be sufficiently relaxed by the buffering layer 34 and the peeling between the thermoelectric conversion elements 11 and the second electrode portion 35 can be more accurately suppressed.

In addition, in the present embodiment, in a case where the glass component is present at the interface between the first electrode portion 25 and the first insulating layer 21, and the first electrode portion 25 in at least the region in which the thermoelectric conversion elements 11 are disposed has a thickness of 5 $\mu$m or more and a porosity P of less than 10%, the first electrode portion 25 is formed to be dense and thick, so that it is possible to reduce the electrical resistance. In addition, since there are few pores inside the first electrode portion 25, deterioration of the thermoelectric conversion elements 11 due to gas inside the pores can be suppressed. Furthermore, since the glass component is present at the interface between the first electrode portion 25 and the first insulating layer 21, the first electrode portion 25 and the first insulating layer 21 are firmly bonded to each other due to the reaction between the glass component and ceramic, so that bonding reliability is excellent.

Furthermore, in the present embodiment, in a case where the first electrode portion 25 consists of the glass-containing region 25A and the glass-free region 25B in order from the first insulating layer 21 side in the laminating direction, and Ta/(Ta + Tg) is more than 0 and 0.5 or less when the thickness of the glass-containing region 25A in the laminating direction is indicated as Tg and the thickness of the glass-free region 25B in the laminating direction is indicated as Ta, it is possible to suppress the occurrence of peeling at an interface between the glass-containing region 25A and the glass-free region 25B. In addition, since Ta/(Ta + Tg) is more than 0, no glass component is present on a bonding surface to the thermoelectric conversion elements 11, and it is possible to improve a bonding property between the thermoelectric conversion elements 11 and the first electrode portion 25.

In addition, in the present embodiment, in a case where the second electrode portion 35 in at least the region in which the thermoelectric conversion elements 11 are disposed has a thickness of 5 $\mu$m or more and a porosity of less than 10%, the second electrode portion 35 is formed to be dense and thick, so that it is possible to reduce the electrical resistance. In addition, since there are few pores inside the second electrode portion 35, deterioration of the thermoelectric conversion elements 11 due to gas inside the pores can be suppressed.

Furthermore, in the present embodiment, in a case where the arithmetic average roughness Ra of the surface of the first electrode portion 25 facing the thermoelectric conversion element 11 side is 1 $\mu$m or less, an initial bonding rate between the first electrode portion 25 and the thermoelectric conversion elements 11 is excellent, and a change in the electrical resistance during use is small.

In addition, in the present embodiment, in a case where the arithmetic average roughness Ra of the surface of the second electrode portion 35 facing the thermoelectric conversion element 11 side is set to be 1.50 $\mu$m or less, an initial bonding rate between the second electrode portion 35 and the thermoelectric conversion elements 11 is excellent, and a change in the electrical resistance during use is small.

In the method for producing a thermoelectric conversion module in the present embodiment, since the first electrode portion bonding step S04 of bonding the first end of the thermoelectric conversion elements 11 and the first electrode portion 25 to each other and the second electrode portion bonding step S05 of bonding the second end of the thermoelectric conversion elements 11 and the second electrode portion 35 to each other are simultaneously performed, the thermoelectric conversion module 10 can be produced relatively easily.

In addition, since the buffering layer 34 is formed in the second insulating circuit substrate 30, even in the case where the first electrode portion bonding step S04 and the second electrode portion bonding step S05 are simultaneously performed, thermal stress due to a temperature difference from the temperature at the time of bonding can be relaxed by the buffering layer 34 in the second insulating circuit substrate 30 disposed in the low-temperature environment, so that peeling between the thermoelectric conversion elements 11 and the second electrode portion 35 can be suppressed.

Furthermore, in the present embodiment, in the first electrode portion bonding step S04, in a case where the pressing load is set to be in a range of 20 MPa or more and 50 MPa or less and the heating temperature is set to be in a range of 300°C or higher and 700°C or lower, the first electrode portion 25 can have a dense structure.

In the present embodiment, since the first electrode portion bonding step S04 and the second electrode portion bonding step S05 are simultaneously performed, the second electrode portion 35 can also have a dense structure.

While the embodiment of the present invention has been described above, the present invention is not limited thereto, and can be appropriately changed without departing from the technical features of the invention.

For example, in the present embodiment, it has been described that in the laminating step S03, the thermoelectric conversion elements 11 are directly laminated on the first electrode portion 25 and the second electrode portion 35 and subjected to solid-phase diffusion bonding, but the present invention is not limited thereto. A Ag bonding material may be disposed on the first electrode portion 25 and the second electrode portion 35, then the thermoelectric conversion elements 11 may be disposed thereon, and bonding may be performed using the Ag bonding material. Moreover, solder may be used for bonding to a low-temperature side of the thermoelectric conversion module.

In this case, a first bonding layer is formed between the first electrode portion 25 and the thermoelectric conversion elements 11 and a second bonding layer is formed between the second electrode portion 35 and the thermoelectric conversion elements 11.

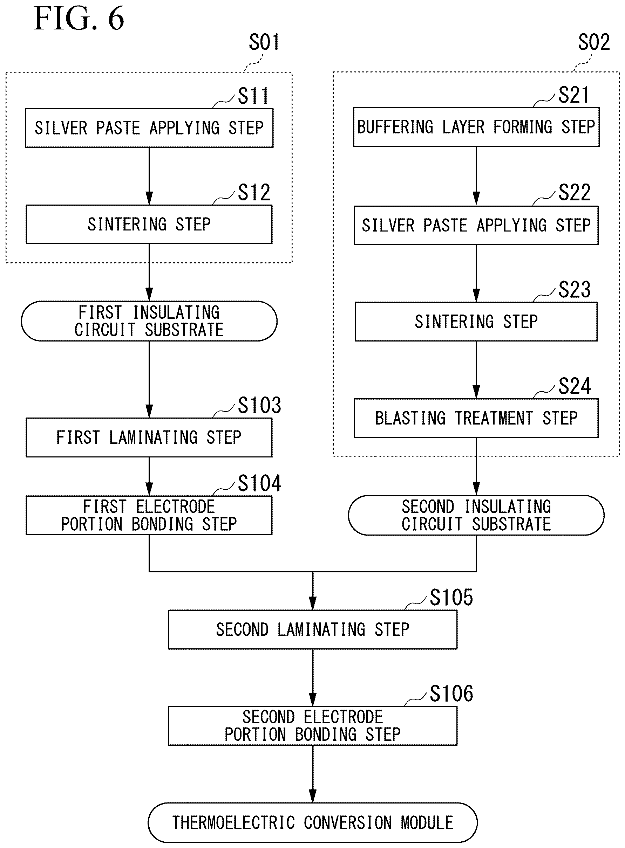

In addition, in the present embodiment, as shown in FIG. 3, it has been described that the first electrode portion bonding step S04 and the second electrode portion bonding step S05 are simultaneously performed, but the present invention is not limited thereto. For example, as shown in FIG. 6, a first laminating step S103 and a first electrode portion bonding step S104 may be performed, and then a second laminating step S105 and a second electrode portion bonding step S106 may be performed. In this case, it is preferable that in the first electrode portion bonding step S104, the first end of the thermoelectric conversion elements and the first electrode portion are bonded to each other at a temperature in a range of 300°C or higher and 700°C or lower, and subsequently, in the second electrode portion bonding step S106, the second end of the thermoelectric conversion elements and the second electrode portion are bonded to each other at a temperature in a range of 200°C or higher and 500°C or lower. It is preferable that in the first electrode portion bonding step S104, a pressing load is set to be in a range of 20 MPa or more and 50 MPa or less, and a heating temperature is set to be in a range of 300°C or higher and 500°C or lower.

In this case, in the second insulating circuit substrate disposed in the low-temperature environment, a temperature difference from the temperature at the time of bonding can be reduced, so that it is possible to suppress the thermal stress to a low level.

[Examples]

Results of a confirmation experiment conducted to confirm the effect of the present invention will be described below.

A glass-containing silver paste was applied onto a surface of a ceramic substrate (thickness 635 $\mu$m) made of alumina and sintered to form a first electrode portion (thickness 100 $\mu$m) made of a silver sintered body; and thereby, a first insulating circuit substrate (20 mm × 20 mm) was produced.

In addition, an aluminum sheet (thickness 200 $\mu$m) having a purity of 99.99 mass% or more was bonded to each of both surfaces of a ceramic substrate (thickness 635 $\mu$m) made of aluminum nitride to form a buffering layer and a heat dissipation layer, and a glass-containing silver paste was applied onto a surface of the buffering layer and sintered to form a second electrode portion (thickness 100 $\mu$m) made of a silver sintered body. Thereby, a second insulating circuit substrate (20 mm × 24 mm) was produced.

Next, a total of 16 thermoelectric conversion elements (3 mm × 3 mm × thickness (height) 5 mm) made of a half-Heuslers alloy, including 8 p-type thermoelectric conversion elements and 8 n-type thermoelectric conversion elements, were prepared and allowed to stand so that the p-type thermoelectric conversion element and the n-type thermoelectric conversion element were alternately disposed in an arrangement of 4 rows and 4 columns.

Then, the first insulating circuit substrate was laminated on one end of the thermoelectric conversion elements in a standing direction, and the second insulating circuit substrate was laminated on the other end of the thermoelectric conversion elements in the standing direction. In addition, circuit patterns were formed in each of the first electrode portion and the second electrode portion such that 16 thermoelectric conversion elements were electrically connected in series.

Then, in a vacuum atmosphere, a laminate of the first insulating circuit substrate, the thermoelectric conversion elements, and the second insulating circuit substrate was held at a holding temperature of 380°C for 60 minutes in a state of being pressed at a load of 30 MPa in a laminating direction, and the thermoelectric conversion elements, the first electrode portion, and the second electrode portion were subjected to solid-phase diffusion bonding.

As described above, a thermoelectric conversion module of the present example was produced.

The obtained thermoelectric conversion module was subjected to a high-temperature durability test.

A thermal cycle of 550°C to 50°C was applied to a high-temperature side (first insulating circuit substrate side), and water at a temperature of 50°C was circulated on a low-temperature side (second insulating circuit substrate side). A load of 1000 N was applied in a vacuum atmosphere using PEM-2 manufactured by ADVANCE RIKO, Inc.

Then, at a predetermined number of cycles, an open circuit voltage, an internal resistance, and a maximum output were measured. Table 1 shows evaluation results.

[Table 1]

| Number of cycles | High-temperature side temperature (°C) | Low-temperature side temperature (°C) | Open circuit voltage (V) | Internal resistance (Ω) | Maximum output (W) |
|---|---|---|---|---|---|
| Initial | 550 | 62.3 | 1.59 | 0.195 | 3.24 |
| 100 | 550 | 62.2 | 1.59 | 0.195 | 3.26 |
| 200 | 550 | 62.2 | 1.59 | 0.195 | 3.24 |
| 300 | 550 | 62.2 | 1.59 | 0.195 | 3.24 |
| 400 | 550 | 62.2 | 1.59 | 0.195 | 3.23 |
| 500 | 550 | 62.1 | 1.59 | 0.195 | 3.22 |
| 600 | 550 | 62.1 | 1.58 | 0.195 | 3.22 |
| 700 | 550 | 62.0 | 1.58 | 0.195 | 3.21 |
| 800 | 550 | 62.1 | 1.58 | 0.196 | 3.21 |
| 900 | 550 | 62.0 | 1.58 | 0.196 | 3.21 |
| 1000 | 550 | 62.0 | 1.58 | 0.196 | 3.20 |

It was confirmed that in the thermoelectric conversion module of the present example, even when the number of cycles was increased, there was no significant change in the open circuit voltage, the internal resistance, and the maximum output, and the thermoelectric conversion module could be used stably.

[Industrial Applicability]

The thermoelectric conversion module of the present embodiment is suitably applied to a Peltier element or a thermoelectric conversion element that performs cooling and temperature control of precision instruments, small refrigerators, and the like.

[Reference Signs List]

[0181]

　　　　10: Thermoelectric conversion module
　　　　11: Thermoelectric conversion element
　　　　20: First insulating circuit substrate
　　　　21: First insulating layer
　　　　25: First electrode portion
　　　　30: Second insulating circuit substrate
　　　　31: Second insulating layer
　　　　34: Buffering layer
　　　　35: Second electrode portion

Claims

1.    A thermoelectric conversion module comprising:

　　　　a plurality of thermoelectric conversion elements that stand at distances from each other;
　　　　a first electrode portion disposed at a first end of the thermoelectric conversion elements in a standing direction; and
　　　　a second electrode portion disposed at a second end in the standing direction,
　　　　wherein the plurality of thermoelectric conversion elements are electrically connected to each other via the first electrode portion and the second electrode portion,

a first insulating circuit substrate including: a first insulating layer made of ceramic; and the first electrode portion made of a silver sintered body which is formed on a surface of the first insulating layer is disposed at the first end, and

a second insulating circuit substrate including: a second insulating layer made of ceramic or a resin; a buffering layer made of aluminum or copper which is formed on a surface of the second insulating layer; and the second electrode portion laminated on the buffering layer is disposed at the second end.

2. The thermoelectric conversion module according to Claim 1,
wherein a thickness of the buffering layer is in a range of 50 $\mu$m or more and 2000 $\mu$m or less.

3. The thermoelectric conversion module according to Claim 1 or 2,

wherein a glass component is present at an interface between the first electrode portion and the first insulating layer, and

the first electrode portion in at least a region in which the thermoelectric conversion elements are disposed has a thickness of 5 $\mu$m or more and a porosity of less than 10%.

4. The thermoelectric conversion module according to any one of Claims 1 to 3,

wherein the first electrode portion consists of a glass-containing region and a glass-free region in order from a first insulating layer side in a laminating direction, and

when a thickness of the glass-containing region in the laminating direction is indicated as Tg and a thickness of the glass-free region in the laminating direction is indicated as Ta, Ta/(Ta + Tg) is more than 0 and 0.5 or less.

5. The thermoelectric conversion module according to any one of Claims 1 to 4,
wherein the second electrode portion in at least a region in which the thermoelectric conversion elements are disposed has a thickness of 5 $\mu$m or more and a porosity of less than 10%.

6. The thermoelectric conversion module according to any one of Claims 1 to 5,
wherein an arithmetic average roughness Ra of a surface of the first electrode portion facing a thermoelectric conversion element side is 1 $\mu$m or less.

7. The thermoelectric conversion module according to any one of Claims 1 to 6,
wherein an arithmetic average roughness Ra of a surface of the second electrode portion facing a thermoelectric conversion element side is 1.50 $\mu$m or less.

8. A method for producing a thermoelectric conversion module including:

a plurality of thermoelectric conversion elements that stand at distances from each other;
a first electrode portion disposed at a first end of the thermoelectric conversion elements in a standing direction; and
a second electrode portion disposed at a second end in the standing direction,
wherein the plurality of thermoelectric conversion elements are electrically connected to each other via the first electrode portion and the second electrode portion, and
in the thermoelectric conversion module, a first insulating circuit substrate including: a first insulating layer having at least one surface made of ceramic; and the first electrode portion made of a silver sintered body which is formed on the one surface of the first insulating layer is disposed at the first end, and a second insulating circuit substrate including: a second insulating layer made of ceramic or a resin; a buffering layer made of aluminum or copper which is formed on a surface of the second insulating layer; and the second electrode portion laminated on the buffering layer is disposed at the second end,
the method comprising:

a first electrode portion bonding step of bonding the first end of the thermoelectric conversion elements and the first electrode portion to each other; and
a second electrode portion bonding step of bonding the second end of the thermoelectric conversion elements and the second electrode portion to each other,
wherein the first electrode portion bonding step and the second electrode portion bonding step are simultaneously performed.

9. The method for producing a thermoelectric conversion module according to Claim 8,

wherein, in the first electrode portion bonding step and the second electrode portion bonding step which are simultaneously performed, a pressing load is set to be in a range of 20 MPa or more and 50 MPa or less and a heating temperature is set to be in a range of 300°C or higher and 500°C or lower, and
the method further includes:
a pressing holding step of subsequently holding the first electrode portion at a temperature of 500°C or higher and 700°C or lower, holding the second electrode portion at a temperature of 100°C or lower, and holding a pressing load to be 1 MPa or more and 50 MPa or less.

10. A method for producing a thermoelectric conversion module including:

a plurality of thermoelectric conversion elements that stand at distances from each other;
a first electrode portion disposed at a first end of the thermoelectric conversion elements in a standing direction; and
a second electrode portion disposed at a second end in the standing direction,
wherein the plurality of thermoelectric conversion elements are electrically connected to each other via the first electrode portion and the second electrode portion, and
in the thermoelectric conversion module, a first insulating circuit substrate including: a first insulating layer having at least one surface made of ceramic; and the first electrode portion made of a silver sintered body which is formed on the one surface of the first insulating layer is disposed at the first end, and a second insulating circuit substrate including: a second insulating layer made of ceramic or a resin; a buffering layer made of aluminum or copper which is formed on a surface of the second insulating layer; and the second electrode portion laminated on the buffering layer is disposed at the second end,
the method comprising:

a first electrode portion bonding step of bonding the first end of the thermoelectric conversion elements and the first electrode portion to each other; and
a second electrode portion bonding step of bonding the second end of the thermoelectric conversion elements and the second electrode portion to each other,
wherein, in the first electrode portion bonding step, the thermoelectric conversion elements and the first electrode portion are bonded to each other at a temperature in a range of 300°C or higher and 700°C or lower, and
subsequently, in the second electrode portion bonding step, the thermoelectric conversion elements and the second electrode portion are bonded to each other at a temperature in a range of 200°C or higher and 500°C or lower.

11. The method for producing a thermoelectric conversion module according to Claim 10,
wherein, in the first electrode portion bonding step, a pressing load is set to be in a range of 20 MPa or more and 50 MPa or less, and a heating temperature is set to be in a range of 300°C or higher and 500°C or lower.

FIG. 1

FIG. 2

# FIG. 3

S01

S11
SILVER PASTE APPLYING STEP

S12
SINTERING STEP

FIRST INSULATING
CIRCUIT SUBSTRATE

S02

S21
BUFFERING LAYER FORMING STEP

S22
SILVER PASTE APPLYING STEP

S23
SINTERING STEP

S24
BLASTING TREATMENT STEP

SECOND INSULATING
CIRCUIT SUBSTRATE

S03
LAMINATING STEP

S04, 05
FIRST ELECTRODE PORTION
BONDING STEP/SECOND ELECTRODE
PORTION BONDING STEP

THERMOELECTRIC CONVERSION MODULE

# FIG. 4

## FIG. 5

# FIG. 6

S01

**S11** SILVER PASTE APPLYING STEP

↓

**S12** SINTERING STEP

↓

FIRST INSULATING CIRCUIT SUBSTRATE

↓

**S103** FIRST LAMINATING STEP

↓

**S104** FIRST ELECTRODE PORTION BONDING STEP

S02

**S21** BUFFERING LAYER FORMING STEP

↓

**S22** SILVER PASTE APPLYING STEP

↓

**S23** SINTERING STEP

↓

**S24** BLASTING TREATMENT STEP

↓

SECOND INSULATING CIRCUIT SUBSTRATE

↓

**S105** SECOND LAMINATING STEP

↓

**S106** SECOND ELECTRODE PORTION BONDING STEP

↓

THERMOELECTRIC CONVERSION MODULE

## INTERNATIONAL SEARCH REPORT

| International application No. |
| --- |
| **PCT/JP2022/003553** |

| A. | CLASSIFICATION OF SUBJECT MATTER |
| --- | --- |

*H01L 35/08*(2006.01)i; *H01L 35/32*(2006.01)i; *H01L 35/34*(2006.01)i; *H02N 11/00*(2006.01)i
FI:  H01L35/08; H01L35/32 A; H01L35/34; H02N11/00

According to International Patent Classification (IPC) or to both national classification and IPC

| B. | FIELDS SEARCHED |
| --- | --- |

Minimum documentation searched (classification system followed by classification symbols)

H01L35/08; H01L35/32; H01L35/34; H02N11/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2008-277584 A (YAMAHA CORP.) 13 November 2008 (2008-11-13) paragraphs [0017]-[0022], fig. 1 | 1-11 |
| A | KR 10-2017-0127992 A (TMSTECH CO., LTD.) 22 November 2017 (2017-11-22) paragraphs [0067]-[0078], fig. 3 | 1-11 |
| A | JP 2019-016786 A (MITSUBISHI MATERIALS CORP.) 31 January 2019 (2019-01-31) paragraphs [0031]-[0083], fig. 1-4 | 1-11 |
| A | WO 2020/189543 A1 (MITSUBISHI MATERIALS CORP.) 24 September 2020 (2020-09-24) paragraph [0048], fig. 6 | 1-11 |
| A | JP 2019-012829 A (MITSUBISHI MATERIALS CORP.) 24 January 2019 (2019-01-24) entire text, all drawings | 1-11 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 April 2022** | **10 May 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2022/003553**

| Patent document cited in search report | | | Publication date (day/month/year) | Patent family member(s) | | | Publication date (day/month/year) |
|---|---|---|---|---|---|---|---|
| JP | 2008-277584 | A | 13 November 2008 | (Family: none) | | | |
| KR | 10-2017-0127992 | A | 22 November 2017 | (Family: none) | | | |
| JP | 2019-016786 | A | 31 January 2019 | US | 2021/0111327 | A1 | |
| | | | | paragraphs [0053]-[0151], fig. 1-4 | | | |
| | | | | WO | 2019/009202 | A1 | |
| | | | | EP | 3651217 | A1 | |
| | | | | TW | 201917917 | A | |
| | | | | CN | 110710008 | A | |
| | | | | KR | 10-2020-0026797 | A | |
| WO | 2020/189543 | A1 | 24 September 2020 | TW | 202040774 | A | |
| | | | | JP | 2020-150215 | A | |
| JP | 2019-012829 | A | 24 January 2019 | US | 2020/0144472 | A1 | |
| | | | | entire text, all drawings | | | |
| | | | | WO | 2019/004429 | A1 | |
| | | | | EP | 3648186 | A1 | |
| | | | | TW | 201906202 | A | |
| | | | | CN | 110770924 | A | |
| | | | | KR | 10-2020-0023300 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021015612 A
- JP 2021200808 A
- JP 2019016786 A
- JP 2019012829 A